# FASCICULE DE BREVET EUROPEEN

(11) **EP 2 307 897 B1**
(45) Date de publication et mention de la délivrance du brevet: **01.07.2015**
(21) Numéro de dépôt: 09769538.1
(22) Date de dépôt: 25.06.2009
(51) Int. Cl.: G01R 33/02, G01R 33/025, G01R 33/09, G01R 33/022

(54) **DISPOSITIF ET PROCÉDÉ DE MESURE DE CHAMP MAGNÉTIQUE.**
MAGNETFELD-MESSEINRICHTUNG UND VERFAHREN
MAGNETIC FIELD MEASUREMENT DEVICE AND METHOD

(30) Priorité: 27.06.2008 FR 0854330
(43) Date de publication de la demande: 13.04.2011
(73) Titulaire: Centre National d'Etudes Spatiales, 75001 Paris (FR)
(72) Inventeur: DOMENY, Sébastien, F-30200 Saint Laurent De Carnols (FR); DESPLATS, Romain, F-31320 Castanet Tolosan (FR)
(74) Mandataire: Blot, Philippe Robert Emile
(86) Numéro de dépôt international: PCT/FR2009/051221
(87) Numéro de publication internationale: WO 2009/156697

(56) Documents cités:
- EP-A- 0 807 827
- WO-A-02/06845
- WO-A-98/38792
- WO-A-03/091654
- FR-A- 2 860 878
- GB-A- 2 171 523
- US-A- 5 519 318
- US-A1- 2004 021 461
- US-B1- 6 888 353
- GLAAS W ET AL: "An AMR Sensor-Based Measurement System for Magnetoelectrical Resistivity Tomography" IEEE SENSORS JOURNAL, IEEE SERVICE CENTER, NEW YORK, NY, US, vol. 5, no. 2, 1 avril 2005 (2005-04-01), pages 233-241, XP011128745 ISSN: 1530-437X
- PELEGRI SEBASTIA ET AL: "Signal conditioning for GMR magnetic sensors" SENSORS AND ACTUATORS A, ELSEVIER SEQUOIA S.A., LAUSANNE, CH, vol. 137, no. 2, 15 juin 2007 (2007-06-15), pages 230-235, XP022117864 ISSN: 0924-4247
- MAPPS D J: "Magnetoresistive sensors" SENSORS AND ACTUATORS A, ELSEVIER SEQUOIA S.A., LAUSANNE, CH, vol. 59, no. 1-3, 1 avril 1997 (1997-04-01), pages 9-19, XP004117059 ISSN: 0924-4247
- WARIT WICHAKOOL ET AL: "Magnetic endotracheal tube imaging device" ENGINEERING IN MEDICINE AND BIOLOGY SOCIETY, 2008. EMBS 2008. 30TH ANNUAL INTERNATIONAL CONFERENCE OF THE IEEE, IEEE, PISCATAWAY, NJ, USA, 20 août 2008 (2008-08-20), pages 985-988, XP031346854 ISBN: 978-1-4244-1814-5

## Description

La présente invention concerne un dispositif de mesure de champ magnétique et un procédé de mesure de champ magnétique.

Le document FR-A1 -2 860 878 décrit un dispositif de mesure de champ magnétique, ayant pour but notamment de mesurer un courant électrique parcourant un fil, en utilisant le gradient de champ magnétique obtenu entre un premier capteur et un deuxième capteur. Ce dispositif connu permet d'annuler l'effet du champ magnétique terrestre, pratiquement constant en tout point de l'espace, grâce à la soustraction effectuée pour obtenir le gradient.

Les documents US-A-5,519,318, EP-A-0 807 827 et le document Glaas W et al : « An AMR Sensor-Based Measurement System for Magnetoelectrical Resistivity Tomography », IEEE SENSORS JOURNAL, vol. 5, no. 2, 1 avril 2005, décrivent également un tel dispositif.

Néanmoins, d'autres sources de bruit magnétique autres que le champ magnétique terrestre (appareils électriques par exemple), sont susceptibles de perturber la mesure. Or, certaines de ces autres sources de bruit ne sont pas constantes dans l'espace, de sorte que le dispositif connu y est toujours sensible.

L'invention a pour but de proposer un dispositif de mesure de champ magnétique peu sensible aux sources de bruit magnétique de l'environnement qui ne sont pas constantes dans l'espace.

A cet effet, l'invention a pour objet un dispositif de mesure de champ magnétique comme décrit dans la revendication 1 et un procédé de mesure de champ magnétique comme décrit dans la revendication 10. D'autres caractéristiques de l'invention se trouvent dans les revendications dépendantes.

Ces caractéristiques de l'invention, ainsi que d'autres, apparaîtront à la lecture de la description qui va suivre de modes de réalisation préférés de l'invention. La description est donnée uniquement à titre d'exemple, en se référant aux dessins annexés, parmi lesquels:
- la figure 1 représente un premier dispositif de mesure de champ magnétique selon un premier mode de réalisation de l'invention,
- la figure 2 représente un cycle d'hystérésis d'un capteur magnéto résistif,
- la figure 3 représente les étapes d'un procédé d'utilisation du premier dispositif de mesure de champ magnétique de la figure 1,
- la figure 4 représente un cycle d'hystérésis lors de l'utilisation du premier dispositif,
- la figure 5 représente un second dispositif de mesure de champ magnétique selon un second mode de réalisation de l'invention, et
- la figure 6 représente un troisième dispositif de mesure de champ magnétique selon un troisième mode de réalisation de l'invention.

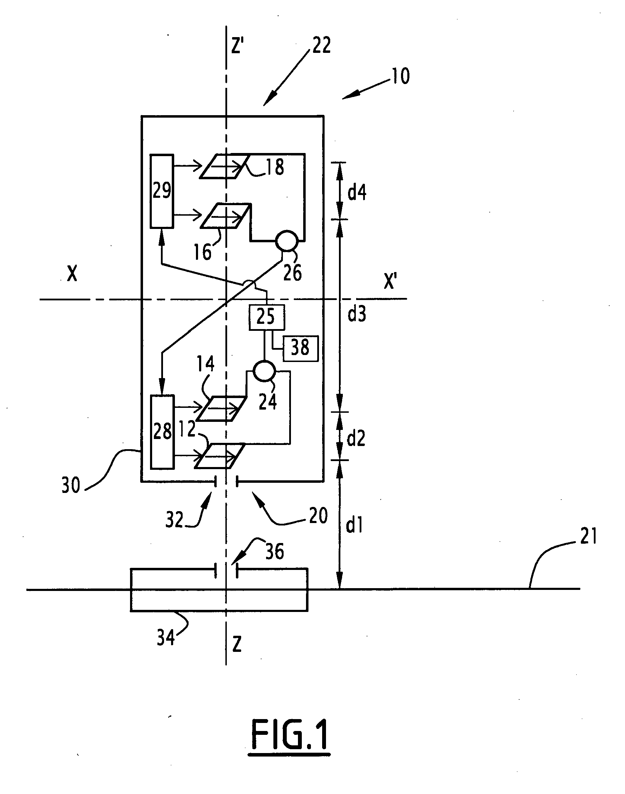

On a représenté sur la figure 1, un premier dispositif 10 de mesure de champ magnétique.

Le premier dispositif 10 se présente sous la forme d'un appareil allongé selon un axe longitudinal ZZ', dont la forme et les dimensions correspondent généralement à celles d'un stylo. Il est donc adapté pour être déplacé manuellement, ou bien au moyen d'un bras motorisé, au-dessus d'un circuit électrique par exemple, avec l'axe longitudinal ZZ' perpendiculaire au plan du circuit.

Le premier dispositif 10 comprend quatre capteurs de champ magnétiques 12, 14, 16, 18. Les quatre capteurs 12, 14, 16, 18 sont des capteurs magnéto-résistifs, et plus précisément des capteurs GMR (« Giant Magnéto Résistance »). Un capteur magnéto-résistif est un élément électronique ayant une résistance qui varie en fonction du champ magnétique B dans lequel il est placé. Chaque capteur GMR 12, 14, 16, 18 présente un axe de mesure privilégié, indiqué schématiquement par une flèche sur la figure 1. La résistance du capteur est influencée essentiellement par la composante Bₓ du champ magnétique B suivant cet axe de mesure privilégié. Le capteur fournit en sortie une tension V qui dépend de la composante B_{X} de champ magnétique suivant l'axe de mesure privilégié. Dans la suite, la composante Bₓ de champ magnétique sera simplement appelée champ magnétique B_{X}.

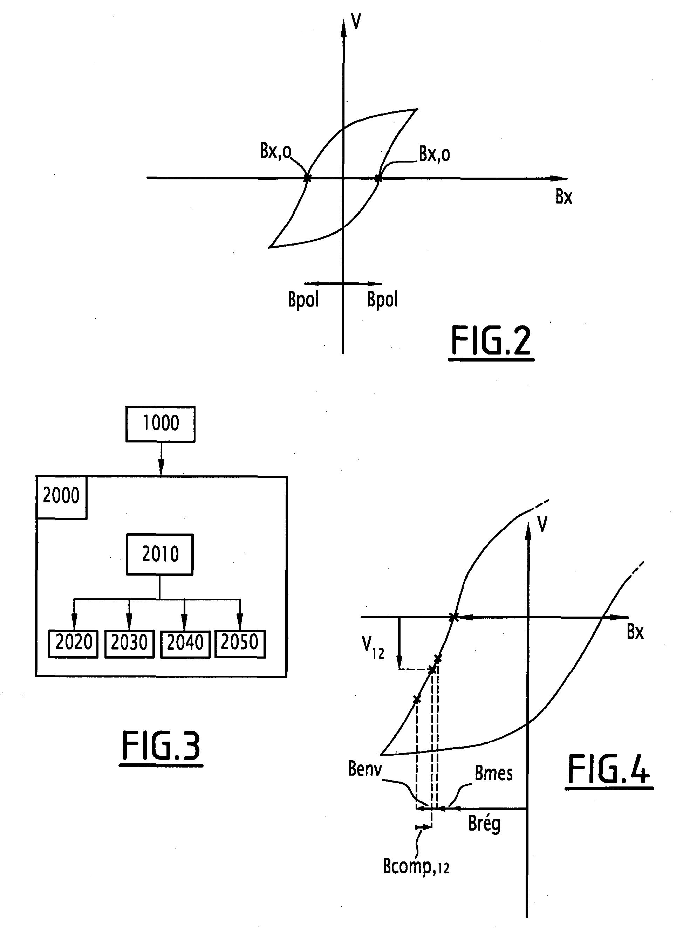

En référence à la figure 2, un capteur magnéto-résistif a la particularité de présenter une courbe d'hystérésis entre sa tension de sortie V et le champ magnétique B_{X}. Cette courbe a généralement la forme de deux « S » décalés suivant le champ magnétique B_{X}, et reliés ensemble à leurs extrémités. La courbe d'hystérésis comprend deux zones sensiblement linéaires, chacune sur un « S » respectif. Une bonne résolution de mesure est obtenue lorsque le point de fonctionnement, c'est-à-dire le point de la courbe d'hystérésis reliant la tension de sortie V au champ magnétique B_{X,0} se déplace dans l'une des deux zones sensiblement linéaires. La courbe d'hystérésis comprend deux points « zéros » B_{X,0} pour lesquels la tension de sortie V est nulle. Un point zéro est obtenu pour un champ magnétique de point zéro correspondant B_{X,0}. Lorsque le champ magnétique B_{X} varie autour du champ magnétique de point zéro B_{X,0}, la tension de sortie V varie sur une plage quasi-linéaire, offrant ainsi une résolution de mesure optimum.

De retour à la figure 1, dans le premier dispositif 10, les quatre capteurs 12, 14, 16, 18 sont disposés dans quatre plans respectifs, parallèles entre eux et perpendiculaires à l'axe ZZ'. Les quatre capteurs 12, 14, 16, 18 sont orientés dans leur plan respectif de sorte que leurs axes de mesure privilégiés soient parallèles entre eux. Dans l'exemple considéré, les axes de mesure privilégiés s'étendent parallèlement à un axe transversal XX' du dispositif, perpendiculaire à l'axe longitudinal ZZ'.

Le premier dispositif 10 comprend, suivant l'axe longitudinal ZZ', une partie avant 20 destinée à venir à proximité d'une source de champ magnétique à évaluer, dans l'exemple illustré un fil 21 parcouru par un courant électrique générant un champ magnétique à mesurer Bₘₑₛ. Le premier dispositif 10 comprend également une partie arrière 22, à l'opposé de la partie avant 20.

Les deux capteurs 12, 14 situés, le long de l'axe ZZ', du côté de la partie avant 20 seront appelés par la suite capteurs avant 12, 14, tandis que les deux capteurs 16, 18 situés, le long de l'axe ZZ', du côté de la partie arrière 22 seront appelé par la suite capteurs arrière 16, 18.

Le capteur 12 le plus à l'avant est destiné à être approché à une distance d1 selon l'axe longitudinal ZZ' de la source à mesurer 21.

Les premier et deuxième capteurs sont espacés l'un de l'autre selon l'axe longitudinal ZZ' d'une distance d2, tandis que les troisième et quatrième capteurs sont espacés l'un de l'autre selon l'axe longitudinal ZZ' d'une distance d4.

Une distance d3 selon l'axe longitudinal ZZ' sépare les paires avant et arrière de capteurs. Cette distance d3 est de préférence au moins quatre fois plus grande que les distances d2, d4 entre capteurs d'une paire.

A titre d'exemple, pour mesurer un courant dans un fil, compris entre 0,1 ampère et 1 ampère, les distances suivantes seront utilisées :
- d1 entre 1 millimètre et 5 millimètres,
- d2 entre 3 millimètres et 7 millimètres, de préférence 5 millimètres,
- d3, entre 1 centimètre et 3 centimètres, de préférence 2 centimètres,
- d4 comme d2.

En cas de champ magnétique de l'environnement plus fort, une distance d3 plus grande est utilisée.

De préférence, les deux capteurs avant 12, 14 et/ou les deux capteurs arrière 16, 18, sont légèrement décalés, de 100 microns à quelques millimètres, de préférence 2mm, l'un de l'autre transversalement, de part et d'autre de l'axe ZZ', pour éviter les problèmes d'écrantage magnétique entre les deux capteurs d'une paire.

De préférence également, les deux capteurs arrière 16, 18 sont décalés transversalement des deux capteurs avant 12, 14, de 1mm à 2cm, de préférence 3mm, pour éviter les problèmes d'écrantage magnétique entre les paires avant et arrière de capteurs.

La demande de brevet FR-A1-2 860 878 apporte des détails sur une réalisation possible de la paire de capteurs avant 12, 14, ou de la paire de capteurs arrière 16, 18.

Le premier dispositif 10 comprend en outre un premier soustracteur 24 réalisant la différence entre les mesures effectuées par les capteurs avant 12, 14, afin d'obtenir un gradient dBₐᵥₐₙₜ de champ magnétique, dit gradient avant.

Le premier dispositif 10 comprend en outre des moyens de traitement 25 du gradient avant dBₐᵥₐₙₜ, afin de déterminer la valeur du courant passant dans le fil 21.

Le premier dispositif 10 comprend en outre des premiers moyens 26 de création de champs de polarisation, configurés pour créer un champ de polarisation B_{pol,12}, B_{pol,14} respectif pour chacun des capteurs avant 12,14.

Le premier dispositif 10 comprend en outre un second soustracteur 28 réalisant la différence entre les mesures effectuées par les capteurs arrière 16, 18, afin d'obtenir un gradient dB_{arrière} de champ magnétique, dit gradient arrière.

Par ailleurs, le premier dispositif 10 comprend en outre des seconds moyens 29 de création de champs de polarisation, configurés pour créer un champ de polarisation B_{pol,16} B_{pol,18} respectivement pour chacun des capteurs arrière 16, 18.

Les seconds moyens 29 de création de champs de polarisation sont reliés aux moyens de traitement 25, afin que ces seconds moyens 29 de création de champs de polarisation crée les champs de polarisation B_{pol,16}, B_{pol,18} à partir du gradient avant dBₐᵥₐₙₜ obtenu par le premier soustracteur 24.

Les premiers 28 et/ou seconds 29 moyens de création de champs de polarisation comprennent, dans une première réalisation, d'une part, un fil électrique respectif pour chaque capteur, s'étendant sous ce capteur et perpendiculairement à son axe de mesure et, d'autre part, des moyens pour créer un courant de polarisation dans chacun des fils électriques. Le courant de polarisation est propre à chacun des capteurs avant 12, 14. En alternative, le courant est identique pour chacun des capteurs avant 12, 14, ce qui simplifie la conception.

En variante, un seul fil électrique est utilisé pour chaque paire de capteurs. Dans ce cas, l'unique fil électrique s'étend entre les deux capteurs de la paire, et les moyens de création de champs de polarisation comprennent des moyens pour créer un courant de polarisation dans le fil électrique unique.

Dans une deuxième réalisation, le fil ou les fils sont chacun remplacés par un bobinage.

Dans la première ou la deuxième réalisation, un aimant permanent est préférentiellement introduit, afin de créer un champ de polarisation permanent. Dans ce cas, les fils ou les bobinages servent à faire un ajustement précis du champ de polarisation.

Dans une troisième réalisation, le fil ou les fils sont remplacé par un aimant créant un champ de polarisation permanent. Les moyens de création de champs de polarisation sont alors aptes à déplacer l'aimant, afin de faire varier le champ de polarisation au niveau de chacun des capteurs de la paire.

Pour diminuer la sensibilité du premier dispositif 10 au champ d'environnement, ce premier dispositif 10 comprend en outre une enceinte de blindage électromagnétique 30 entourant les quatre capteurs 12, 14, 16, 18, cette enceinte étant percée d'une ouverture 32 le long de l'axe longitudinal ZZ', du côté des premier et deuxième capteurs, c'est-à-dire du côté avant 20 du dispositif 10.

D'une manière similaire, le fil 21 est entouré d'une enceinte tubulaire de blindage magnétique 34, percée d'une ouverture 36, en face de laquelle l'avant 20 du dispositif 10 est approché, et en particulier l'ouverture 32 du premier dispositif 10.

En variante, le premier dispositif 10 comprend en outre des moyens de stockage 38 et les moyens de traitement 25 sont configurés pour enregistrer dans le support de stockage une suite de valeurs successives au cours du temps prises par le gradient avant dBₐᵥₐₙₜ, qui est compensé comme cela sera expliqué par la suite. Les moyens de traitement 25 sont en outre configurés pour comparer la suite de valeurs enregistrée avec une ou plusieurs suites de valeurs de référence. Cette variante est en particulier prévue dans le dispositif 10 pour les utilisations décrites à la fin de la description.

En référence à la figure 3, on va à présent décrire un exemple de fonctionnement du premier dispositif 10.

Le fonctionnement du premier dispositif 10 comprend tout d'abord une étape de calibration 1000, au cours de laquelle les premiers et seconds moyens 28, 29 de création de champ magnétique de polarisation sont réglés de manière à créer des champs de polarisation de réglage B_{rég}, respectivement pour chacun des capteurs 12, 14, 16, 18. Les champs de polarisation de réglage sont tels que chacun des quatre capteurs 12, 14, 16, 18 a un point de fonctionnement situé sensiblement sur un point zéro de la courbe d'hystérésis, en l'absence de champ à mesurer Bₘₑₛ et de champ d'environnement Bₑₙᵥ.

Le fonctionnement du premier dispositif 10 comprend en outre une étape 2000 d'utilisation.

L'étape 2000 d'utilisation comprend une étape 2010 de placement du premier dispositif 10 dans une position d'utilisation, qui est la positon représentée sur la figure 1. Dans cette position d'utilisation, l'axe longitudinal ZZ' pointe vers la source à mesurer, qui est le fil 21 dans l'exemple décrit, avec la partie avant 20 du premier dispositif dirigée vers la source à mesurer.

Ainsi, les capteurs avant 12, 14 sont soumis au champ magnétique Bₘₑₛ généré par le fil 21 et au champ magnétique de l'environnement Bₑₙᵥ, que l'on suppose généré par des sources de bruits éloignées.

Du fait de la décroissance rapide des champs magnétiques (en 1/r²), l'influence du fil 21 sur les capteurs arrière 16, 18 est négligeable. Ces capteurs arrière 16, 18 sont ainsi soumis au champ magnétique de l'environnement, mais pas au champ magnétique généré par le fil 21.

L'étape 2000 d'utilisation comprend ainsi une étape 2020 de mesure de champ magnétique par chacun des capteurs 12, 14, 16, 18, afin de produire les tensions de sortie V₁₂, V₁₄, V₁₆, V₁₈ correspondantes.

L'étape 2000 d'utilisation comprend en outre une étape 2030 de calcul, par le second soustracteur 29, du gradient arrière dB_{arrière} à partir des tensions de sortie V₁₆, V₁₈ des capteurs arrière 16, 18.

L'étape 2000 d'utilisation comprend en outre une étape 2040 de création par les premiers moyens 28, de champs de polarisation de compensation B_{comp,12}, B_{comp,14} pour les capteurs avant 12, 14. Cette étape 2040 est illustrée sur la figure 4 pour le capteur avant 12. Les champs de polarisation de compensation s'ajoutent aux champs de polarisation de réglage déterminés lors de l'étape 1000 de calibration. Les champs de polarisation B_{comp,12}, B_{comp},₁₄ de compensation sont déterminés, à partir du gradient arrière dB_{arrière}, de manière à compenser, au moins en partie, le champ d'environnement Bₑₙᵥ pour chacun des capteurs avant 12,14.

Ainsi, grâce aux champs de polarisation de compensation B_{comp,12}, B_{comp,14}, le gradient avant dBₐᵥₐₙₜ est également compensé, au moins en partie.

De retour à la figure 4, l'étape 2000 d'utilisation comprend en outre une étape 2050 de détermination, par les moyens de traitement 25, d'une valeur du courant passant dans le fil 21, à partir du gradient avant dBₐᵥₐₙₜ, compensé grâce aux champs de compensation B_{comp,12} et B_{comp,14} précédents.

Les étapes 2020 à 2050 sont réalisées en parallèle, et en continu.

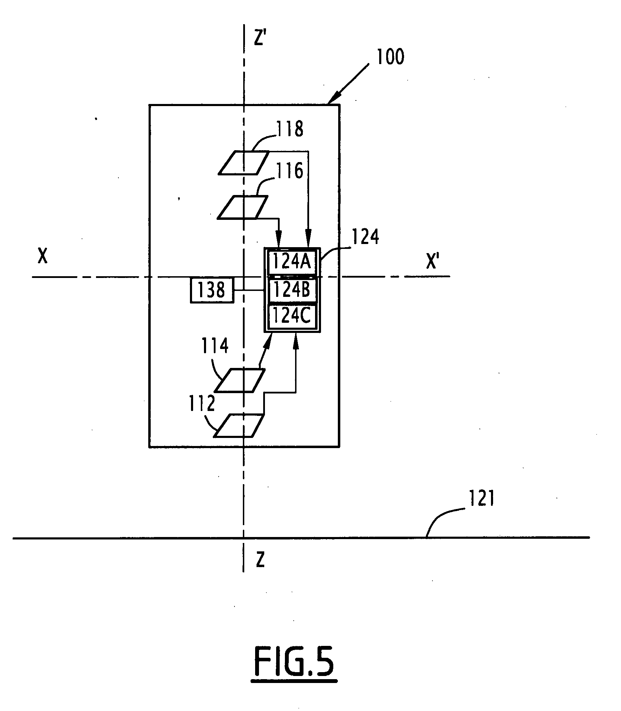

En référence à la figure 5, un second dispositif 110 selon l'invention de mesure de champ magnétique généré par un courant passant dans un fil 121 est représenté.

De même que pour le premier dispositif de la figure 1, le second dispositif 110 se présente sous la forme d'un appareil allongé le long d'un axe longitudinal ZZ', dont la forme et les dimensions correspondent généralement à celles d'un stylo. Le second dispositif 110 comprend en outre quatre capteurs de champ magnétique 112, 114, 116, 118 agencés respectivement de la même manière que les quatre capteurs 12, 14, 16, 18 du premier dispositif.

Les quatre capteurs 112, 114, 116, 118 sont soit des capteurs directionnels, auquel cas leurs axes de mesure sont orientés comme pour le premier dispositif 10, soit des capteurs omnidirectionnels. Les capteurs sont par exemple des capteurs magnéto-résistifs ou bien magnéto-inductifs.

Le second dispositif 110 comprend en outre une unité de calcul numérique 124 agencée pour recevoir les mesures des quatre capteurs 112, 114, 116, 118. L'unité de calcul numérique 124 est par exemple un microcontrôleur.

L'unité de calcul numérique 124 comprend des premières instructions 124A pour réaliser la soustraction des mesures des deux capteurs arrière 116, 118 pour obtenir un gradient arrière dB_{arrière}.

L'unité de calcul numérique 124 comprend en outre des secondes instructions 124B pour réaliser la soustraction des mesures des deux capteurs avant 112, 114 pour obtenir un gradient avant dBₐᵥₐₙₜ. L'unité de calcul numérique 124 remplit ainsi la fonction des soustracteurs 24 et 26 du premier dispositif 10.

L'unité de calcul numérique 124 comprend en outre des instructions 124C pour réaliser la soustraction des deux gradients avant dBₐᵥₐₙₜ et arrière dB_{arrière} obtenus, afin de compenser, au moins en partie, le champ magnétique de l'environnement dans le gradient avant dBₐᵥₐₙₜ.

Les distances entre les capteurs 112, 114, 116, 118 sont choisies de la même manière que pour le premier dispositif 10.

Le fonctionnement du second dispositif est similaire à celui du premier dispositif 10.

Comme pour le premier dispositif 10, en variante, le second dispositif 100 comprend en outre un support de stockage 138 et l'unité de calcul numérique 124 est configurée pour enregistrer dans le support de stockage 138 une suite de valeurs successives au cours du temps, prises par le gradient avant dBₐᵥₐₙₜ compensé. L'unité de calcul numérique 124 est en outre configurée pour comparer la suite de valeurs enregistrée avec une ou plusieurs suites de valeurs de référence. Cette variante est en particulier prévue dans le dispositif 100 pour les utilisations décrites à la fin de la description.

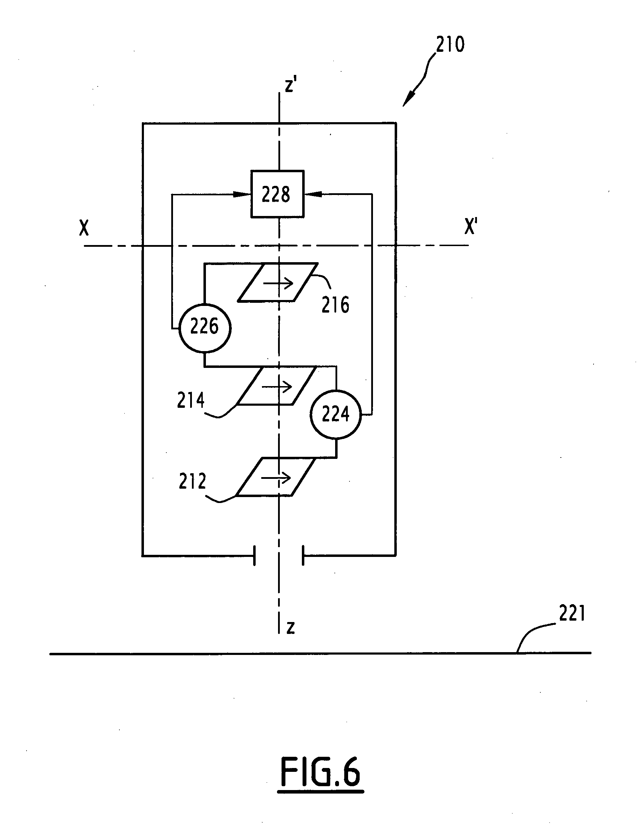

En référence à la figure 6, un troisième dispositif 210 de mesure de champ magnétique comprend trois capteurs 212, 214, 216 de champ magnétique, à la place des quatre capteurs de la figure 1 ou 2.

Comme précédemment, les capteurs sont alignés le long d'un axe longitudinal ZZ', avec un capteur proche 212 destiné à être approché d'une source formée dans l'exemple à nouveau par un fil 221 parcouru par un courant, un capteur intermédiaire 214 et un capteur éloigné 216 destiné à être éloigné de la source. Des premiers moyens de soustraction 224 sont alors reliés au capteur proche 212 et au capteur intermédiaire 214, qui forment ainsi une première paire de capteurs, et des seconds moyens de soustraction 226 sont alors reliés au capteur intermédiaire 214 et au capteur éloigné 216 qui forment ainsi une seconde paire de capteurs.

Les premier et second moyens de soustraction sont réalisés de la même manière que dans le premier dispositif 10, ou bien de la même manière que dans le second dispositif 110.

Le troisième dispositif 210 comprend en outre des moyens de traitement 228 pour compenser, au moins en partie, le champ magnétique de l'environnement dans le gradient avant dBₐᵥₐₙₜ, à partir du gradient arrière dB_{arrière}, et par exemple en réalisant la soustraction du gradient arrière dB_{arrière} dans le gradient avant dBₐᵥₐₙₜ.

En variante, les seconds moyens de soustraction sont reliés au capteur proche 212 et au capteur éloigné 216.

L'utilisation d'un dispositif selon l'invention ne se limite pas au champ magnétique généré par un courant passant dans un fil.

Dans une autre utilisation, un dispositif selon l'invention est utilisé pour localiser ou mesurer le champ magnétique généré par un aimant permanent constitué d'un matériau ferromagnétique.

Dans une autre utilisation, au lieu de déplacer le dispositif selon l'invention à proximité de la source de champ magnétique, ce dispositif est gardé fixe et la source de courant est déplacée.

La validation et/ou détection d'un billet de banque, tel qu'un billet de banque européen est un exemple de cette utilisation. En effet, chaque billet de banque a une signature magnétique liée probablement à l'utilisation d'une encre magnétique. Une signature magnétique correspond aux valeurs successives de champ magnétique mesurées par le dispositif au cours du temps, c'est-à-dire au cours du défilement du billet de banque. Ainsi il est prévu de faire glisser des billets de banque suivant leur longueur, à une vitesse connue, à une même distance au dessous du dispositif de mesure de l'invention. Le dispositif de mesure permet alors de mesurer la signature caractéristique de chaque billet de banque défilant. Les billets de montants différents sont alors différenciés en passant sous le dispositif, par la détection de leur signature caractéristique et leur comparaison par les moyens 25 ou 124 à des signatures de référence. Grâce à l'invention et en particulier au double différentiel, la détection des signatures caractéristiques est robuste, car peu sensible aux perturbations du champ magnétique de l'environnement voisin du dispositif.

Dans une autre utilisation, le champ magnétique que l'on cherche à mesurer n'est pas un champ magnétique continu, mais un champ magnétique alternatif, variant selon une fréquence caractéristique.

Cette utilisation permet par exemple de valider le passage d'un signal caractéristique à une fréquence donnée, dans une tresse de plusieurs fils de la même couleur. Ainsi, sans avoir à localiser et identifier chacun des fils, on peut mesurer le champ magnétique, en déduire la fréquence et confirmer le passage des signaux aux fréquences mesurées.

Dans une autre utilisation, un dispositif selon l'invention est utilisé pour mesurer des signaux notamment numériques passant dans un conducteur entre deux composants électroniques. Dans cet exemple, le signal électrique consiste en une succession de « zéros » et « uns » logique formant un message du type « 10011000 » sur 8 bits. Un « un » logique correspond à une tension de 3V et un « zéro » logique à une tension de 0V dans notre exemple. A ces variations de tensions est nécessairement associé le passage d'un courant qui varie en fonction de ces variations de tensions. Ces variations de courant génèrent un champ magnétique caractéristique du message. Un dispositif selon l'invention est utilisé pour mesurer, le champ magnétique généré par les variations de courant, permettant la détermination des messages conduits par le conducteur, par exemple le message « 10011000, en comparant la suite des valeurs enregistrée avec des suites de valeurs de référence correspondant à des messages connus. A nouveau, un avantage de l'utilisation d'un dispositif selon l'invention est sa faible sensibilité aux champs magnétiques voisins, en particulier au champ magnétique généré par l'alimentation du dispositif électronique, fournissant du courant pour tous les composants. En effet, ce champ magnétique de l'alimentation est un champ magnétique de grande amplitude, et qui, sans l'utilisation d'un dispositif selon l'invention, masquerait les mesures fines comme celle de notre exemple.

## Revendications

1. Dispositif de mesure de champ magnétique orienté suivant un axe longitudinal (ZZ'), le dispositif comprenant :
- au moins quatre capteurs de champ magnétique (12, 14, 16, 18),
+ fournissant chacun une mesure de champ magnétique,
+ répartis en deux paires de capteurs (12 et 14, 16 et 18), les deux paires n'ayant aucun capteur en commun,
- des premiers moyens de soustraction (24 ; 124 ; 224) des mesures des deux capteurs de la première paire, pour obtenir un premier gradient de champ magnétique,
- des seconds moyens de soustraction (26 ; 126 ; 226) des mesures des deux capteurs de la seconde paire, pour obtenir un second gradient de champ magnétique, le dispositif comprenant suivant l'axe longitudinal (Z'Z) une partie avant (20) destinée à venir à proximité d'une source (21 ;121 ; 221) d'un champ magnétique à mesurer, la première paire de capteurs étant plus proche de la partie avant (20) que la seconde paire de capteurs,
caractérisé ce que le dispositif comprend en outre :
- des moyens de création (28) de champs de polarisation pour les capteurs (12, 14) de la première paire déterminés à partir du second gradient de champ magnétique fourni par les seconds moyens de soustraction (24).

2. Dispositif selon la revendication 1, **caractérisé en ce que** les aux moins quatre capteurs de champ magnétique sont espacés les uns des autres le long d'un axe longitudinal (ZZ'), les capteurs étant répartis en deux paires de deux capteurs successifs le long de l'axe longitudinal (ZZ'), l'axe longitudinal (ZZ') étant destiné, en position d'utilisation du dispositif, à être pointé sensiblement vers la source de champ magnétique, avec la première paire plus proche de la source de champ magnétique que la seconde paire.

3. Dispositif selon la revendication 2, **caractérisé en outre en ce que** les capteurs de la première paire sont décalés l'un de l'autre transversalement à l'axe longitudinal (ZZ').

4. Dispositif selon la revendication 2 ou 3, **caractérisé en outre en ce que** les capteurs de la seconde paire sont décalés l'un de l'autre transversalement à l'axe longitudinal (ZZ').

5. Dispositif selon l'une quelconque des revendications 1 à 4, **caractérisé en outre en ce que** chacun des au moins quatre capteurs est un capteur omnidirectionnel.

6. Dispositif selon l'une quelconque des revendications 1 à 4, **caractérisé en outre en ce que** chacun des au moins quatre capteurs est un capteur directionnel avec un axe de mesure privilégié sensiblement parallèle à un axe (XX') transversal à l'axe longitudinal (ZZ').

7. Dispositif selon la revendication 6, **caractérisé en outre en ce que** le dispositif comprend une enceinte de blindage électromagnétique (30) entourant les au moins quatre trois capteurs, cette enceinte (30) étant percée d'une ouverture (32) le long de l'axe longitudinal (ZZ'), du côté de la première paire de capteurs..

8. Dispositif selon la revendication 7, **caractérisé en outre en ce que** la première paire de capteurs est décalée de la deuxième paire de capteurs transversalement à l'axe longitudinal (ZZ').

9. Dispositif selon la revendication 6, **caractérisé en outre en ce que** les premier (12) et deuxième (14) capteurs de la première paire sont des capteurs GMR, présentant un cycle d'hystérésis.

10. Procédé de mesure de champ magnétique, comprenant:
- le placement d'au moins quatre capteurs :
+ fournissant chacun une mesure de champ magnétique,
+ les capteurs étant répartis en deux paires de capteurs (12 et 14, 16 et 18, les deux paires n'ayant aucun capteur en commun,
dans une position d'utilisation, dans laquelle la première paire est approchée d'une source de champ magnétique à mesurer et dans laquelle la seconde paire est éloignée de la source,
- la réception d'aux moins quatre signaux de mesure de champ magnétique des au moins quatre capteurs de champ magnétique,
- la soustraction des signaux des deux capteurs de la première paire, pour obtenir un premier gradient de champ magnétique,
- la soustraction des signaux des deux capteurs de la seconde paire, pour obtenir un second gradient de champ magnétique,
- la création de champs de polarisation pour les capteurs de la première paire déterminés à partir du second gradient de champ magnétique.

11. Procédé selon la revendication 10, **caractérisé en outre en ce qu'**il comprend l'enregistrement dans un support de stockage d'une suite de valeurs successives au cours du temps de premier gradient champ magnétique obtenu avec création de champs de polarisation pour les capteurs de la première paire.

12. Procédé selon la revendication 11, **caractérisé en outre en ce qu'**il comprend la comparaison de la suite de valeurs avec une ou plusieurs suites de valeurs de référence.

## Patentansprüche

1. Magnetfeld- Messvorrichtung, die gemäß einer Längsachse (ZZ') ausgerichtet ist, wobei die Vorrichtung umfasst:
- mindestens vier Magnetfeldsensoren (12, 14, 16, 18),
+ die jeweils eine Magnetfeldmessung bereitstellen,
+ die in zwei Sensorpaaren (12 und 14, 16 und 18) verteilt sind, wobei die zwei Paare keinen Sensor gemeinsam haben,
- erste Subtraktionsmittel (24; 124; 224) der Messungen der zwei Sensoren des ersten Paars, um einen ersten Magnetfeldgradienten zu erhalten,
- zweite Subtraktionsmittel (26; 126; 226) der Messungen der zwei Sensoren des zweiten Paars, um einen zweiten Magnetfeldgradienten zu erhalten,
wobei die Vorrichtung gemäß der Längsachse (Z'Z) einen vorderen Abschnitt (20) umfasst, der bestimmt ist, in die Nähe einer Quelle (21;121; 221) eines zu messenden Magnetfelds zu kommen, wobei das erste Sensorpaar näher am vorderen Abschnitt (20) als das zweite Sensorpaar ist,
**dadurch gekennzeichnet, dass** die Vorrichtung ferner umfasst:
- Bildungsmittel (28) von Polarisationsfeldern für die Sensoren (12, 14) des ersten Paars, die ab dem zweiten Magnetfeldgradienten bestimmt sind, der von den zweiten Subtraktionsmitteln (24) bereitgestellt wird.

2. Vorrichtung nach Anspruch 1, **dadurch gekennzeichnet, dass** die mindestens vier Magnetfeldsensoren entlang einer Längsachse (ZZ') voneinander beabstandet sind, wobei die Sensoren in zwei Paar zu je zwei aufeinanderfolgenden Sensoren entlang der Längsachse (ZZ') aufgeteilt sind, wobei die Längsachse (ZZ') in Benutzungsstellung der Vorrichtung bestimmt ist, mit dem ersten Paar, das der Magnetfeldquelle näher ist als das zweite Paar, etwa zur Magnetfeldquelle zu zeigen.

3. Vorrichtung nach Anspruch 2, ferner **dadurch gekennzeichnet, dass** die Sensoren des ersten Paars transversal zur Längsachse (ZZ') zueinander versetzt sind.

4. Vorrichtung nach Anspruch 2 oder 3, ferner **dadurch gekennzeichnet, dass** die Sensoren des zweiten Paars transversal zur Längsachse (ZZ') zueinander versetzt sind.

5. Vorrichtung nach einem der Ansprüche 1 bis 4, ferner **dadurch gekennzeichnet, dass** jeder der mindestens vier Sensoren ein Allrichtungssensor ist.

6. Vorrichtung nach einem der Ansprüche 1 bis 4, ferner **dadurch gekennzeichnet, dass** jeder der mindestens vier Sensoren ein Richtungssensor mit einer bevorzugten Messachse etwa parallel zu einer zur Längsachse (ZZ') transversalen Achse (XX') ist.

7. Vorrichtung nach Anspruch 6, ferner **dadurch gekennzeichnet, dass** die Vorrichtung eine elektromagnetische Abschirmungsbox (30) umfasst, die die mindestens vier drei Sensoren umgibt, wobei diese Box (30) auf der Seite des ersten Sensorpaars entlang der Längsachse (ZZ') von einer Öffnung (32) durchbrochen ist.

8. Vorrichtung Anspruch 7, ferner **dadurch gekennzeichnet, dass** das erste Sensorpaar vom zweiten Sensorpaar transversal zur Längsachse (ZZ') versetzt ist.

9. Vorrichtung nach Anspruch 6, ferner **dadurch gekennzeichnet, dass** der erste (12) und zweite (14) Sensor des ersten Paars GMR-Sensoren mit einem Hysteresekreis sind.

10. Verfahren der Magnetfeldmessung, umfassend:
- das Platzieren von mindestens vier Sensoren:
+ die jeweils eine Magnetfeldmessung bereitstellen,
+ die in zwei Sensorpaaren (12 und 14, 16 und 18) verteilt sind, wobei die zwei Paare keinen Sensor gemeinsam haben,
in einer Benutzungsstellung, in welcher das erste Paar einer Quelle eines zu messenden Magnetfelds angenähert ist und in welcher das zweite Paar von der Quelle entfernt ist,
- das Empfangen von mindestens vier Magnetfeld-Messsignalen der mindestens vier Magnetfeldsensoren,
- das Subtrahieren der Signale der zwei Sensoren des ersten Paars, um einen ersten Magnetfeldgradienten zu erhalten,
- das Subtrahieren der Signale der zwei Sensoren des zweiten Paars, um einen zweiten Magnetfeldgradienten zu erhalten,
- das Erzeugen von ab dem zweiten Magnetfeldgradienten bestimmten Polarisationsfeldern für die Sensoren des ersten Paars.

11. Verfahren nach Anspruch 10, ferner **dadurch gekennzeichnet, dass** es die Registrierung in einem Speichermedium einer Folge zeitlich aufeinanderfolgender Werte des ersten, mit der Schaffung von Polarisationsfeldern für die Sensoren des ersten Paars erhaltenen Magnetfeldgradienten umfasst.

12. Verfahren nach Anspruch 11, ferner **dadurch gekennzeichnet, dass** es den Vergleich der Wertefolge mit einer oder mehreren Referenzwertefolgen umfasst.

## Claims

1. A device for measuring a magnetic field oriented along a longitudinal axis (ZZ'), the device comprising:
- at least four magnetic field sensors (12, 14, 16, 18),
+ each providing a magnetic field measurement,
+ distributed in two pairs of sensors (12 and 14, 16 and 18), both pairs not having any common sensor,
- first means (24; 124; 224) for subtracting the measurements of both sensors of the first pair, in order to obtain a first magnetic field gradient,
- second means (26; 126; 226) for subtracting the measurements of both sensors of the second pair, in order to obtain a second magnetic field gradient,
the device comprising along the longitudinal axis (ZZ') a front portion (20) intended to come into proximity to a source (21; 121; 221) of a magnetic field to be measured, the first pair of sensors being closer to the front portion (20) than the second pair of sensors,
**characterized in that** the device further comprises:
- means (28) for generating polarization fields for the sensors (12, 14) of the first pair, determined from the second magnetic field gradient provided by the second subtraction means (24).

2. The device according to claim 1, **characterized in that** said at least four magnetic field sensors are spaced apart from each other along a longitudinal axis (ZZ'), the sensors being distributed in two pairs of two successive sensors along the longitudinal axis (ZZ'), the longitudinal axis (ZZ') being intended, in the position of use of the device, to be substantially pointed towards the magnetic field source, with the first pair closer to the magnetic field source than the second pair.

3. The device according to claim 2, further **characterized in that** the sensors of the first pair are shifted relatively to each other transversely to the longitudinal axis (ZZ').

4. The device according to claim 2 or 3, further **characterized in that** the sensors of the second pair are shifted relatively to each other transversely to the longitudinal axis (ZZ').

5. The device according to any of claims 1 to 4, further **characterized in that** each of said at least four sensors is an omnidirectional sensor.

6. The device according to any of claims 1 to 4, further **characterized in that** each of said at least four sensors is a directional sensor with a preferential measurement axis substantially parallel to an axis (XX') transverse to the longitudinal axis (ZZ').

7. The device according to claim 6, further **characterized in that** the device comprises an electromagnetic shielding chamber (30) surrounding said at least three sensors, this chamber (30) being pierced with an aperture (32) along the longitudinal axis (ZZ') on the side of the first pair of sensors.

8. The device according to claim 7, further **characterized in that** the first pair of sensors is shifted from the second pair of sensors transversely to the longitudinal axis (ZZ').

9. The device according to claim 6, further **characterized in that** the first (12) and second (14) sensors of the 1^{st} pair are GMR sensors, having a hysteresis cycle.

10. A method for measuring a magnetic field, comprising:
- placing at least four sensors:
+ each providing a magnetic field measurement,
+ the sensors being distributed in two pairs of sensors (12 and 14, 16 and 18), both pairs not having any common sensor,
in a position of use, in which the first pair is approached by a source of a magnetic field to be measured and in which the second pair is moved away from the source,
- receiving at least four magnetic field measurement signals from said at least four magnetic field sensors,
- subtracting the signals of both sensors of the first pair in order to obtain a first magnetic field gradient,
- subtracting the signals of both sensors of the second pair in order to obtain a second magnetic field gradient,
- generating polarization fields for the sensors of the first pair, determined from the second magnetic field gradient.

11. The method according to claim 10, further **characterized in that** it comprises the recording in a storage medium of a sequence of successive values over time of the first magnetic field gradient obtained with the generation of polarization fields for the sensors of the first pair.

12. The method according to claim 11, further **characterized in that** it comprises the comparison of the sequence of values with one or several sequences of reference values.
